# FASCICULE DE BREVET EUROPEEN

(11) **EP 3 415 464 B1**
(45) Date de publication et mention de la délivrance du brevet: **05.08.2020**
(21) Numéro de dépôt: 18177857.2
(22) Date de dépôt: 14.06.2018
(51) Int. Cl.: B81B 3/00, G01P 15/125

(54) **DISPOSITIF MICROELECTROMECANIQUE À AU MOINS UN ELEMENT MOBILE GUIDÉ EN TRANSLATION**
MIKROELEKTROMECHANISCHE VORRICHTUNG MIT MINDESTENS EINEM BEWEGLICHEN ELEMENT MIT SEITLICHER BEWEGUNGSFÜHRUNG
MICROELECTROMECHANICAL DEVICE HAVING AT LEAST ONE TRANSLATABLY GUIDED MOBILE ELEMENT

(30) Priorité: 16.06.2017 FR 1755480
(43) Date de publication de la demande: 19.12.2018
(73) Titulaire: Commissariat à l'énergie atomique et aux énergies alternatives, 75015 Paris (FR)
(72) Inventeur: MASPERO, Federico, 22063 CANTU (CO) (IT); JOET, Loïc, 38640 CLAIX (FR)
(74) Mandataire: Brevalex

(56) Documents cités:
- WO-A1-2006/110304
- WO-A1-2013/108705
- US-B1- 8 729 770

## Description

La présente invention se rapporte à un dispositif microélectromécanique et/ou nanoélectromécanique à au moins un élément mobile guidé en translation.

Les dispositifs microélectromécanique ou MEMS (Microelectromechanical Systems en terminologie anglo-saxonne) et les dispositifs nanoélectromécanique ou NEMS (Nanoelectromechanical Systems en terminologie anglo-saxonne) sont de plus en plus présents dans les objets du quotidien tels que les téléphones portables, type smartphone, les tablettes tactiles et les montres intelligentes. Ces dispositifs sont utilisés en tant que capteurs, par exemple comme capteurs inertiels et en tant que micro ou nanoactionneurs.

Les dispositifs MEMS et/ ou NEMS comportent au moins un élément mobile formant par exemple une masse dans le cas de capteurs inertiels, tels que les accéléromètres et les gyromètres.

Par exemple dans le cas des accéléromètres, la masse est suspendue et est destinée à être mobile en translation sous l'effet d'une accélération extérieure. Le déplacement en translation est alors mesuré. La masse peut avoir un déplacement hors-plan et/ou un déplacement dans le plan du capteur.

La détection du déplacement de la masse peut être réalisée par différents moyens, par exemple par des moyens capacitifs.

Le document US 2009/0308160 décrit un accéléromètre à déplacement hors-plan à détection capacitive à variation de surface. Sur la figure 12, on peut voir reproduit schématiquement l'accéléromètre du document US2009/0308160. Il comporte une partie mobile 1001 suspendue par des ressorts à une partie fixe. La partie mobile 1001 comporte une masse 1002 fixée à une partie de support d'électrodes 1004 par une portion de couplage 1009 en oxyde. La partie de support d'électrodes 1004 comporte des premières électrodes mobiles 1005 d'une première taille et des deuxièmes électrodes mobiles 1006 d'une deuxième taille. La partie fixe comporte des premières électrodes fixes 1007 d'une première taille et des deuxièmes électrodes fixes 1008 d'une deuxième taille. Les électrodes 1005 et 1007 sont interdigitées et les électrodes 1006 et 1008 sont interdigitées.

Lorsque l'accéléromètre est soumis à une accélération perpendiculaire au plan du capteur, la masse se déplace dans une direction hors-plan, le déplacement de la masse est détecté par la variation de capacité entre les électrodes mobiles et les électrodes fixes.

Cependant la masse peut avoir un mouvement de basculement résultant d'une accélération dans le plan, cette sensibilité aux accélérations dans le plan est d'autant plus grande que les ressorts de suspension ne sont pas dans le plan du centre de gravité de la masse.

Or un tel basculement peut provoquer une non-linéarité dans la mesure du déplacement de la masse, voire mettre en contact les électrodes mobiles et fixes et conduire à un endommagement du capteur.

Le document WO 2013/108705 décrit un condensateur à capacité variable offrant une grande amplitude de mouvement. Le condensateur est formé entre une partie fixe et une partie mobile, articulée par rapport à la partie fixe par des bras articulés en rotation sur le support et sur la partie mobile. La plaque mobile n'est pas guidée en translation de sorte à limiter de manière très importante, voire empêcher sa rotation par rapport à la partie fixe.

### EXPOSÉ DE L'INVENTION

C'est par conséquent un but de la présente invention d'offrir un dispositif MEMS et/ou NEMS comportant un élément mobile en translation dont le guidage en translation est amélioré.

Le but énoncé ci-dessus est atteint par un dispositif MEMS et/ou NEMS comportant au moins un élément mobile destiné à se déplacer en translation le long d'une direction donnée, et des moyens de guidage en translation de l'élément le long de la direction donnée, les moyens de guidage comportant au moins deux bras rigides, chaque bras étant articulé en rotation sur l'élément mobile et le support. En outre une articulation de couplage comportant au moins articulation en rotation entre les deux bras est prévue. Les bras et les axes de rotation sont disposés de sorte que, lors d'un déplacement en translation de l'élément, les articulations en rotation entre les bras et l'élément mobile se déplacent dans le même sens et d'une même distance, et l'articulation de couplage entre les deux bras est sollicitée selon le mode autorisé. Inversement, en cas de pivotement de l'élément mobile, les bras se déplacent dans des sens opposés et l'articulation de couplage est sollicitée dans un mode interdit. Ainsi les bras imposent un mouvement de translation dans ladite direction donnée. L'élément mobile est alors guidé par les bras en translation et ne subit pas de pivotement accidentel dû par exemple à une force dans le plan.

Une partie au moins des articulations en rotation sont telles qu'elles offrent un degré de liberté en translation dans le plan du dispositif le long des bras.

L'élément de couplage est suffisamment court pour offrir un couplage rigide entre les bras et limiter, voire empêcher la rotation de l'élément mobile par rapport au support et assurer un guidage en translation efficace.

L'articulation de couplage est disposée entre des plans contenant les articulations pivots entre les bras et le support, lesdits plans étant parallèles à la direction hors-plan.

De manière avantageuse, le couplage est réalisé par au moins une barre de torsion.

De manière très avantageuse, une partie au moins des articulations en rotation comportent des poutres déformables en torsion.

Dans un exemple, un ou plusieurs moyens de guidage bordent extérieurement l'élément mobile.

Dans un autre exemple de réalisation, le moyen de guidage est logé dans une fenêtre traversant l'élément mobile.

De manière avantageuse, le dispositif comporte plusieurs moyens de guidage. De manière préférée, les axes de rotation d'au moins deux moyens de guidage ne sont pas parallèles, ils sont par exemple orthogonaux.

La présente invention a alors pour objet un dispositif MEMS et/ou NEMS comportant un support et au moins un élément suspendu de sorte à pouvoir se déplacer en translation par rapport au support dans une direction hors-plan par rapport à un plan du dispositif, au moins un moyen de guidage en translation dudit élément, ledit moyen de guidage comportant au moins deux bras rigides s'étendant longitudinalement, une articulation pivot entre chaque bras et l'élément mobile et une articulation pivot entre chaque bras et le support, le moyen de guidage comportant également une articulation de couplage entre les deux bras comportant au moins une articulation pivot, au moins deux des articulations pivots reliées à chacun des bras ayant un degré de liberté en translation dans le plan du dispositif le long des bras, lesdites articulations pivots ayant des axes de rotation au moins parallèles entre eux de sorte que lors d'un déplacement en translation de l'élément mobile les bras pivotent l'un par rapport à l'autre dans des sens opposés , l'articulation de couplage étant disposée entre des plans contenant les articulations pivots entre les bras et le support,lesdits plans étant parallèles à la direction hors-plan.

Dans un exemple particulièrement avantageux, les articulations pivots ayant un degré de liberté en translation dans le plan du dispositif le long des bras comportent au moins une poutre déformable en torsion.

Dans un exemple de réalisation, l'articulation de couplage comporte deux poutres déformables en torsion et un élément rigide reliant les deux poutres, les deux poutres étant par ailleurs fixées chacune à un bras.

Dans un autre exemple de réalisation, l'articulation de couplage comporte une seule poutre déformable en torsion fixée aux deux bras, ladite poutre étant perpendiculaire aux axes longitudinaux des bras.

Selon un exemple de réalisation, les deux bras sont dans deux plans parallèles distincts, chaque bras étant relié à l'élément mobile par une de ses extrémités longitudinales, au support par l'autre de ses extrémités longitudinales et la poutre de l'articulation de couplage s'étendant entre les deux bras dans des zones intermédiaires des bras entre leurs extrémités longitudinales. Le moyen de guidage peut être est disposé le long d'au moins un bord extérieur de l'élément mobile.

Le dispositif peut avantageusement au moins deux moyens de guidage. De préférence, les axes de rotation des deux moyens de guidage sont sécants entre eux.

Selon un autre exemple de réalisation, le moyen de guidage comporte au moins trois bras et l'articulation de couplage comporte au moins trois poutres déformable en torsion reliées entre elles de sorte à former une forme fermée, chaque bras étant fixé à une poutre de l'articulation de couplage de sorte que l'axe longitudinal du bras soit perpendiculaire à l'axe de la poutre.

Le moyen de guidage peut être disposé dans une fenêtre formée à travers l'élément mobile de sorte qu'il soit inclus dans le périmètre de l'élément mobile.

Les au moins trois bras peuvent être disposés les uns par rapport aux autres de sorte que l'articulation de couplage est disposée sensiblement au centre de la croix.

Selon une caractéristique avantageuse, le dispositif MEMS et/ou NEMS peut comporter avantageusement des moyens de butée hors-plan, lesdits moyens de butée étant formés entre le support et au moins un bras d'au moins un moyen de guidage. Par exemple, les moyens de butée hors-plan sont tels qu'ils forment au moins une première butée dans une premier sens de déplacement hors-plan, la première butée étant portée par un des bras en coopération avec le support.

La première butée peut être formée au niveau d'une extrémité longitudinale du bras, et l'articulation pivot entre le bras et l'élément mobile peut être située entre ladite extrémité longitudinale du bras et l'articulation de couplage, à l'exclusion de ladite extrémité longitudinale.

De manière avantageuse, les moyens de butée hors-plan sont tels qu'ils forment également une deuxième butée dans un deuxième sens de déplacement hors-plan.

Dans un exemple préféré, le dispositif MEMS et/ou NEMS comporte des moyens de suspension dudit élément mobile au support distincts du au moins un moyen de guidage.

La présente invention a également pour objet un capteur inertiel comportant au moins un dispositif MEMS et/ou NEMS selon l'invention, l'élément mobile formant une masse inertielle, et des moyens de détection du déplacement hors-plan de la masse inertielle. Par exemple, les moyens de détection sont des moyens de détection capacitifs à variation de surface, lesdits moyens comportant des électrodes interdigités, une partie étant portée par la masse inertielle et l'autre partie étant portée par le support situées au-dessus de la masse inertielle.

### BRÈVE DESCRIPTION DES DESSINS

La présente invention sera mieux comprise sur la base de la description qui va suivre et des dessins en annexe sur lesquels:
- la figure 1A est une représentation d'un dispositif mettant en œuvre des moyens de guidage en translation selon un premier exemple de réalisation, l'élément mobile étant sollicité dans la direction hors-plan,
- la figure 1B représente le dispositif de la figure 1A, l'élément mobile étant sollicité en basculement,
- la figure 1C est une représentation schématique de l'orientation des différents éléments des moyens de guidage dans la situation de la figure 1A,
- la figure 1D est une représentation schématique de l'orientation des différents éléments des moyens de guidage dans la situation de la figure 1B,
- la figure 2 est une représentation en perspective d'un capteur inertiel mettant en œuvre les moyens de guidage du dispositif de la figure 1A,
- les figures 3A et 3B sont des représentations du capteur de la figure 2 dans deux états différents,
- la figure 4 est une représentation d'un dispositif mettant en œuvre des moyens de guidage en translation selon un deuxième exemple de réalisation,
- la figure 5 est une représentation d'un dispositif mettant en œuvre des moyens de guidage en translation selon une variante du deuxième exemple de réalisation,
- la figure 6A une représentation d'un dispositif mettant en œuvre des moyens de guidage en translation selon un troisième exemple de réalisation,
- la figure 6B est une représentation d'une variante du dispositif de la figure 6A,
- la figure 7A est une représentation d'un dispositif mettant en œuvre des moyens de guidage en translation selon un quatrième exemple de réalisation,
- les figures 7B est une représentation d'une variante du dispositif de la figure 7A,
- la figure 7C est une représentation du dispositif de la figure 7B comportant des moyens de butée hors-plan,
- la figure 8 est une représentation d'un dispositif mettant en œuvre des moyens de guidage en translation selon un autre exemple de réalisation,
- la figure 9A est une vue de dessus d'un dispositif mettant en œuvre des moyens de guidage en translation selon le premier exemple de réalisation et comportant en outre des moyens de butée hors-plan,
- la figure 9B est une vue de côté du dispositif de la figure 9A,
- la figure 9C représente, vue de côté, le dispositif des figures 9A et 9B, dans un état de butée,
- les figures 10A à 10G sont des représentations schématiques de différentes étapes d'un exemple de procédé de réalisation des moyens de guidage selon l'invention,
- les figures 11A à 11C sont des représentations schématiques de différentes étapes d'un exemple de procédé de réalisation des moyens de guidage selon l'invention,
- la figure 12 est une vue de côté d'un accéléromètre à déplacement hors-plan de l'état de la technique.

### EXPOSÉ DÉTAILLÉ DE MODES DE RÉALISATION PARTICULIERS

Dans la description qui va suivre, les mêmes références seront utilisées pour des éléments ayant les mêmes fonctions et sensiblement les mêmes formes dans les différents exemples de réalisation.

Le dispositif selon l'invention peut être mis en œuvre par exemple dans un capteur, de type capteur inertiel, l'élément mobile étant une masse inertielle, ou dans un actionneur, l'élément mobile pouvant être un élément optique.

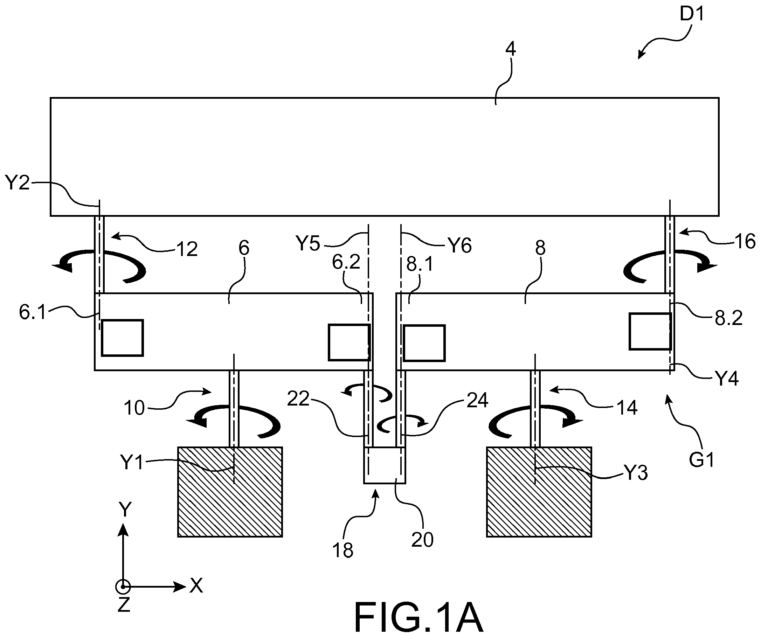

Sur les figures 1A à 1D, on peut voir une représentation schématique d'un dispositif D1 selon l'invention selon un premier exemple de réalisation.

Le dispositif D1 s'étend principalement dans le plan XY. Le dispositif D1 comporte un support 2, un élément destiné à se déplacer le long de la direction Z orthogonal au plan XY. L'élément 4 est suspendu par rapport au support de sorte à pouvoir se déplacer par rapport au support. Dans cette représentation schématique, le support 2 est schématisé par deux plots d'ancrage.

L'élément mobile 4 est considéré comme rigide.

Un élément est désigné comme rigide dans la présente demande, lorsque ses déformations sont négligeables par rapports au déplacement global dans la direction hors-plan.

Le dispositif D1 comporte également de moyens de guidage G1 en translation de l'élément 4 le long de la direction Z.

Les moyens G1 comportent deux bras rigides 6, 8. Dans cet exemple, les deux bras sont alignés le long de la direction X. Chaque bras 6, 8 comporte deux extrémités longitudinales 6.1, 6.2 et 8.1, 8.2 respectivement. Les extrémités 6.2 et 8.1 sont disposées à proximité et sont désignées « extrémités proximales », et les extrémités 6.1 et 8.2 sont désignées « extrémités distales ». Dans cet exemple, les faces des extrémités proximales 6.2 et 8.1 sont en regard.

Le bras 6 est relié mécaniquement au support par une première liaison pivot 10 d'axe Y1 et est relié mécaniquement à l'élément par une deuxième liaison pivot 12 d'axe Y2.

Le bras 8 est relié mécaniquement au support par une troisième liaison pivot 14 d'axe Y3 et est reliée mécaniquement à l'élément par une quatrième liaison pivot 16 d'axe Y4.

Dans l'exemple représenté, la première liaison pivot 10 se situe au centre du bras 6 et la deuxième articulation pivot 12 se situe au niveau de l'extrémité distale 6.1. La troisième articulation pivot 14 se situe au centre du bras 8 et la quatrième liaison pivot 16 se situe au niveau de l'extrémité distale 8.2.

En outre les moyens G1 comportent une articulation 18 entre les deux bras 6, 8, reliant les extrémités proximales 6.2 et 8.1.

L'articulation 18 comporte une pièce rigide 20 et deux liaisons pivots 22, 24 d'axe Y5, Y6, chaque liaison pivot 22, 24 reliant la pièce rigide 20 à une extrémité proximale 6.2, 8.1 respectivement.

Les axes des articulations pivots 10, 12, 14, 16, 22, 24 sont parallèles entre eux.

Au moins deux articulations pivots reliées à chaque bras présente un degré de liberté en translation dans le plan du dispositif le long des bras. Les articulations pivots comportent avantageusement une poutre apte à se déformer en torsion autour de l'axe de pivot. Les poutres offrent une certaine aptitude à la flexion

Dans l'exemple représenté, toutes les liaisons pivots 10, 12, 14, 16, 20, 22 sont réalisées par des poutres aptes à se déformer en torsion autour de l'axe de pivot.

Ce degré de liberté en translation peut être conféré à toutes les articulations pivots. Dans l'exemple représenté et de manière avantageuse, les liaisons pivots sont réalisées par des poutres aptes à se déformer en torsion autour de l'axe de pivot.

Les bras 6 et 8 se déplacent dans un plan P1 parallèle au plan XZ.

Le fonctionnement de l'invention va maintenant être décrit dans le cas d'un accéléromètre, l'élément 4 formant par exemple une masse inertielle.

Lorsque le capteur est soumis à une accélération hors-plan, i.e. le long de la direction Z, la masse inertielle 2 est déplacée en translation le long de la direction Z. Les moyens de guidage G1 accompagnent la masse inertielle. Les bras 6, 8 pivotent autour des liaisons 12, 16 dans des sens opposés, comme cela est schématisé sur la figure 1A. Les liaisons pivots 10 et 14 sont également sollicitées dans des directions opposées, ainsi que les liaisons 22, 24. L'articulation 18 impose un même déplacement hors plan aux extrémités distales 6.1, 8.2, et donc, impose aux bras de pivoter dans des sens opposés.

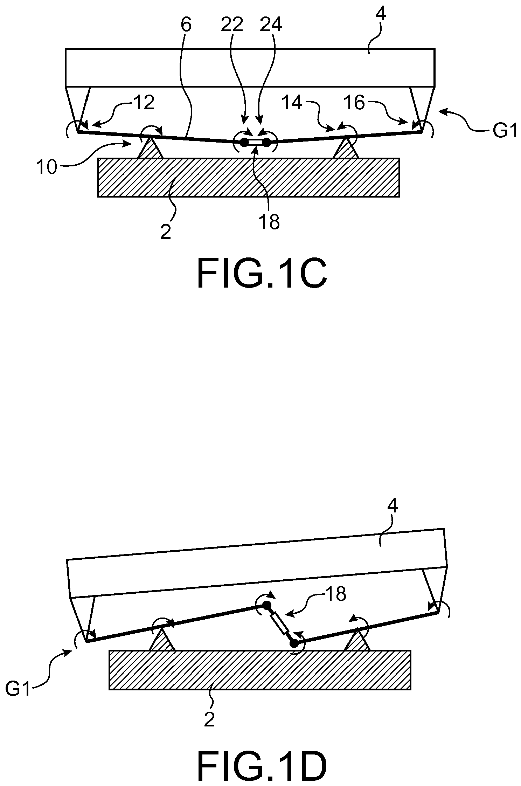

Par ailleurs, puisque les bras et leurs liaisons pivots sont symétriques l'un de l'autre, les extrémités distales se déplacent de la même distance, imposant à la masse un déplacement parallèle au support (figure 1C).

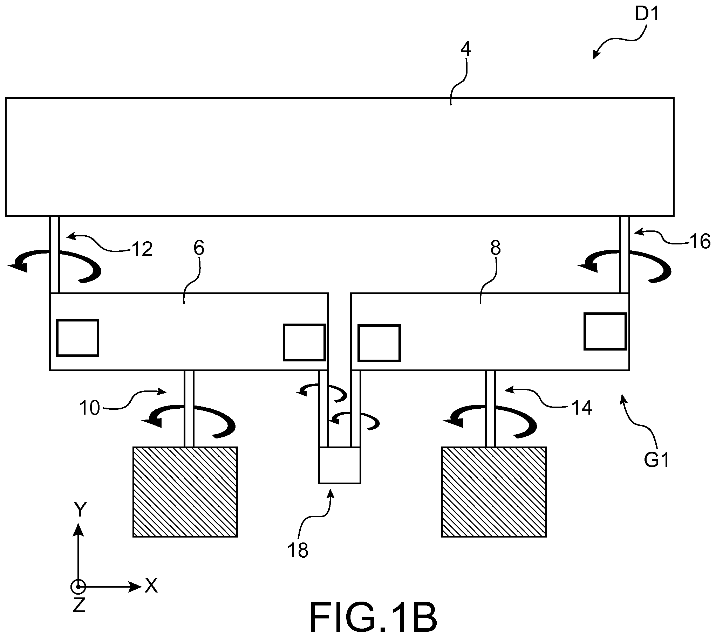

Dans le cas d'une accélération dans le plan, les sens de rotation au niveau de toutes les liaisons pivots sont les mêmes comme cela est représenté sur la figure 1B, ce qui tend à écarter les extrémités proximales 6.2 et 8.1 et à faire basculer la masse inertielle autour d'un axe parallèle à Y.

Or, la mise en œuvre de l'articulation 18 entre les bras, et plus généralement des moyens de guidage G1, augmente la rigidité et réduit, voire empêche, un tel basculement de la masse inertielle, ce qui limite les risques d'une non-linéarité dans la mesure du déplacement de la masse et les risques d'endommagement par contact. L'effet de l'articulation 18 est représenté schématiquement sur la figure 1D. Dans cette représentation, le basculement de la masse est exagéré à des fins d'illustration, mais il sera compris que grâce à l'invention, un basculement d'une telle amplitude n'est pas autorisé

De préférence, le dispositif MEMS et/ou NEMS comporte plusieurs moyens de guidage G1, et au moins deux moyens de guidage dont les bras se déplacent dans des plans P1, P2 orthogonaux réduisant encore davantage les déplacements dans le plan. De manière avantageuse, il comporte trois moyens de guidage, les bras de deux moyens de guidage se déplaçant dans des plans parallèles et les bras des autres moyens de guidage se déplaçant dans un plan orthogonal. Ainsi la rigidité dans le plan offert par les moyens de guidage est sensiblement améliorée.

Les bras 6 et 8 peuvent être de dimensions différentes et/ou les liaisons pivots pourraient ne pas être disposées de manière symétrique. Mais les choix des dimensions et de l'emplacement des liaisons pivots sont faits de sorte que l'élément mobile a effectivement un déplacement hors plan.

Dans des exemples de réalisation, le dispositif peut comporter des moyens de suspension spécifiques de l'élément, en effet les moyens de guidage selon l'invention peuvent ne pas pouvoir assurer la suspension et/ou assurer un maintien dans le plan suffisamment rigide. En effet, les poutres de torsion présentent également une certaine aptitude à la flexion pouvant ne pas offrir un maintien suffisant de l'élément mobile dans le plan.

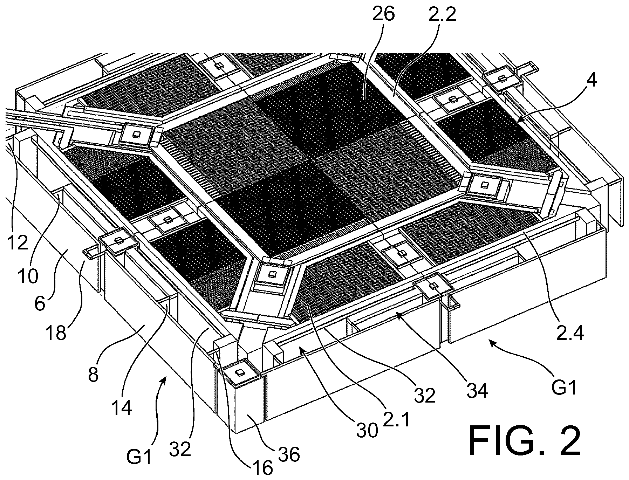

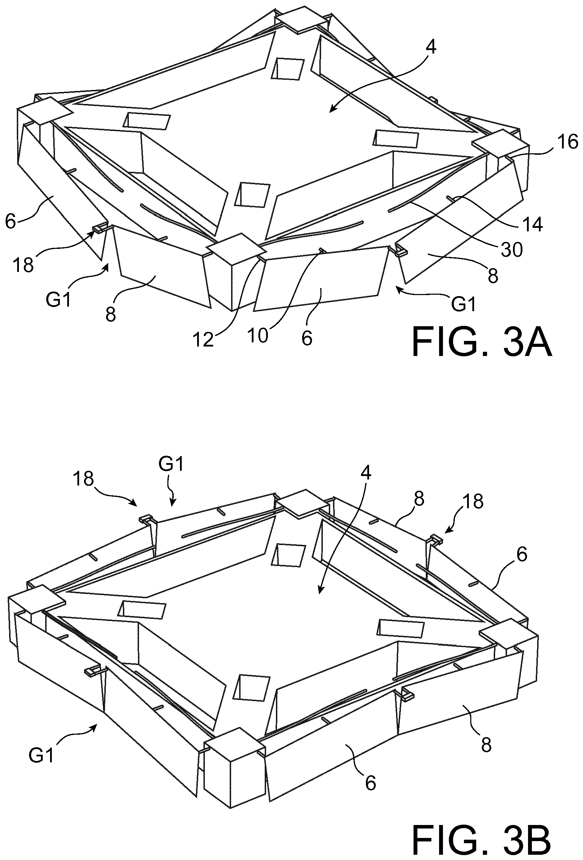

Sur les figures 2 et 3A et 3B, on peut voir représenté partiellement un exemple de réalisation pratique d'un dispositif MEMS et/ou NEMS selon le premier exemple de réalisation, comportant quatre moyens de guidage. Ce dispositif peut être utilisé comme accéléromètre hors-plan.

Ce dispositif permet de réaliser une mesure différentielle du déplacement de la masse.

Le dispositif comporte deux ensembles de détection de sorte à permette la mesure différentielle.

Le dispositif comporte une masse 4 comprenant un cadre extérieur 24 situé au-dessus d'une première partie 2.1 du support et une partie centrale 26 située au-dessous d'une deuxième partie 2.2 du support.

Le cadre et la première partie 2.1 comportent des électrodes interdigitées formant des premiers condensateurs et la partie centrale 26 et la deuxième partie 2.2 comportent des électrodes interdigitées formant des deuxièmes condensateurs. Le déplacement hors-plan de la masse provoque une variation opposée des capacités des premiers et deuxièmes condensateurs, ce qui permet la mesure différentielle.

Le dispositif comporte également les moyens de suspension 30 de la masse par rapport au support 2.

Dans cet exemple, les moyens de suspension 30 sont au nombre de huit, deux par côté de la masse. Ils sont formés chacun par une poutre 32 s'étendant parallèlement à un bord dudit élément mobile et ancrée par une extrémité à un plot d'ancrage 34 du support et par une autre extrémité à la masse. Les poutres 32 sont aptes à se déformer en flexion selon une direction hors-plan. Les poutres 32 sont également déformables en flexion dans le plan, mais le fait de mettre en œuvre 8 poutres 32 est équivalent à opposer au déplacement dans le plan la raideur en compression/étirement importante d'une poutre orthogonale. Ces moyens de suspension assurent donc une certaine rigidité dans le plan.

Le dispositif comporte également des moyens de guidage G1. Chacun des moyens de guidage s'étend le long d'un côté du cadre 26. Les moyens de guidage sont similaires à ceux des figures 1A à 1D.

Les extrémités distales 6.1, 8.2 des bras 6, 8 de chacun des moyens de guidage sont mécaniquement reliées par une liaison pivot aux extrémités longitudinales des bords du cadre de la masse. Dans l'exemple représenté, le support comporte quatre plots d'ancrage 36 situés en regard des quatre sommets de la masse et destinés à coopérer avec les bras 6, 8 pour former des butées comme cela sera décrit plus en détail par la suite.

Dans cet exemple pratique, les bras 6, 8 sont formés par des lames présentant une grande largeur dans la direction Z et offrant donc une grande rigidité dans cette direction.

En outre dans l'exemple représenté, les liaisons pivots et l'articulation 18 se situent dans une partie supérieure des bras 6, 8. Il sera compris que les liaisons pivots et l'articulation 18 peuvent se situées dans des zones intermédiaires et/ou dans une partie inférieure des bras et/ou dans la partie supérieure.

Les moyens de guidage assurent donc le guidage de la masse au niveau de ses quatre sommets.

Les moyens de suspension 30 limitent, voir évitent les mouvements dans le plan. La combinaison des moyens de suspension et des moyens de guidage permet de réaliser un dispositif dont la maîtrise du comportement de la masse est améliorée.

Sur les figures 3A et 3B, on peut voir le dispositif de la figure 2 dans deux états différents. Sur la figure 3A, la masse est en position basse et sur la figure 3B, la masse est en position haute.

Dans l'exemple de la figure 2, l'élément mobile est de forme carrée et comporte quatre moyens de guidage.

On peut envisager que l'élément mobile soit par exemple triangulaire et comporte trois moyens de guidage. Dans ce cas, les plans des différents moyens de guidage sont sécants sans être orthogonaux.

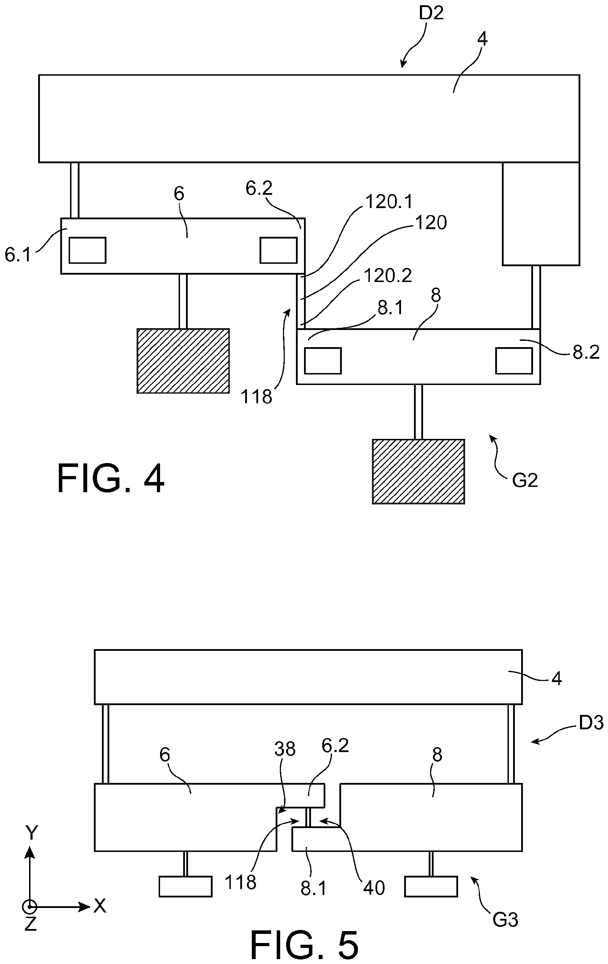

Sur les figures 4 et 5, on peut voir un deuxième exemple de réalisation d'un dispositif selon l'invention.

Le dispositif D2 diffère du dispositif D1 notamment en ce que les moyens de guidages G2 diffèrent des moyens de guidage G1 par l'articulation 118 entre les bras 6, 8.

Sur la figure 4, les bras 6 et 8 sont disposés dans deux plans parallèles. Ainsi les faces des extrémités proximales 6.2, 8.1 ne sont plus en regard mais sensiblement dans un même plan R perpendiculaire au plan des bras 6, 8.

L'articulation 118 comporte une unique poutre ou barre de de torsion 120 s'étendant dans le plan R, dont une extrémité longitudinale 120.1 est reliée mécaniquement à un flanc de la poutre 6 et une autre extrémité 120.2 est reliée mécaniquement à un flanc de la poutre 8 en regard. La mise en œuvre d'une poutre de torsion offre une rigidité augmentée.

Sur la figure 5, on peut voir une variante de dispositif D3 avantageuse du dispositif D2. Dans le dispositif D3, les poutres 6, 8 des moyens de guidage G3 sont telles qu'elles offrent un encombrement réduit par rapport à la structure de D2. Pour cela les extrémités proximales 6.2, 8.1 des poutres comportent une découpe 38, 40 respectivement permettant aux poutres d'être rapprochées.

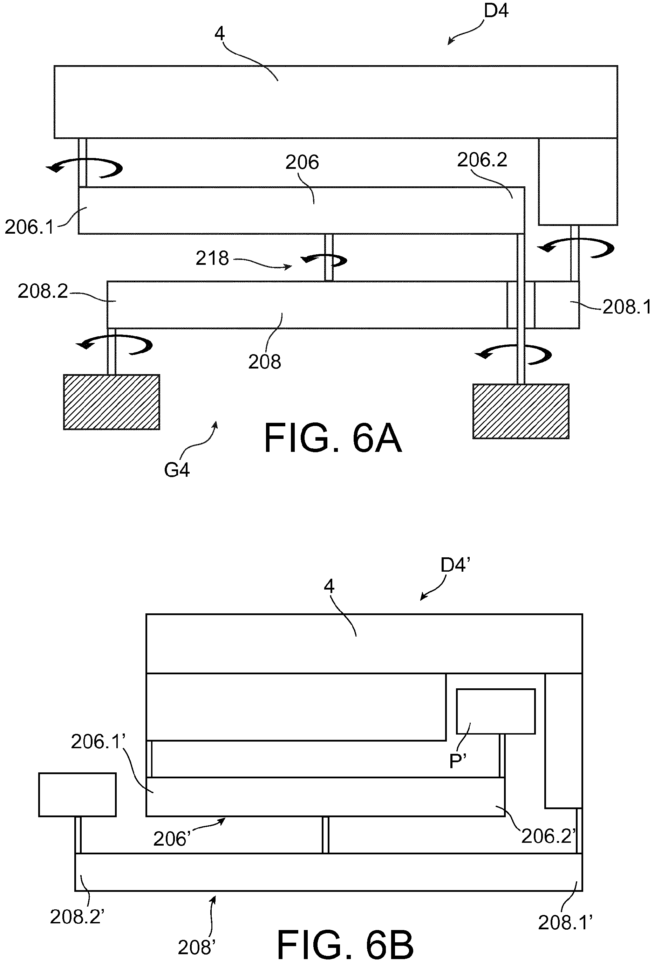

Sur la figure 6A, on peut voir un autre exemple de réalisation d'un dispositif D4 selon l'invention.

Dans le dispositif D4, les dispositions des liaisons pivots sont modifiées par rapport à celles des dispositifs D1 à D3.

Dans le dispositif D4, les moyens de guidage G4 comportent deux bras 206, 208 disposés dans deux plans parallèles et une articulation 218 entre les bras 206, 208.

Une face latérale du bras 206 est en regard d'une face latérale du bras 208 et l'articulation 218 s'étend entre les deux faces latérales. L'articulation de couplage 2018 est formée par une unique barre de torsion.

De manière avantageuse, l'articulation est formée par une poutre déformable en torsion.

La liaison pivot entre la poutre 206 et l'élément mobile est située au niveau d'une extrémité longitudinale 206.1 de la poutre 206, et la liaison pivot entre la poutre 206 et le support est située au niveau de l'autre extrémité longitudinale 206.2 de la poutre 206.

La liaison pivot entre la poutre 208 et l'élément mobile est située au niveau d'une extrémité longitudinale 208.1 de la poutre 208 et la liaison pivot entre la poutre 208 et le support est située au niveau de l'autre extrémité longitudinale 208.2 de la poutre 208.

Les liaisons pivots sont avantageusement réalisées par des poutres déformables en torsion.

Dans l'exemple représenté, la liaison pivot entre l'extrémité 206.2 de la poutre 206 et le support croise la poutre 208, elle est située dans un plan disposé entre le support et la poutre 208 afin de ne pas gêner le déplacement de la poutre 208.

Dans cet exemple de réalisation, les bras présentent une longueur augmentée par rapport aux bras des dispositifs D1 à D3. Il en résulte que pour un même déplacement hors-plan de l'élément mobile, le déplacement angulaire des bras est réduit. D'un côté, il est alors possible de mettre en œuvre au moins une articulation 218 plus rigide, rendant le dispositif plus rigide. D'un autre côté, la raideur du barre de torsion face à un mouvement souhaité est réduite et permet d'obtenir des fréquences de résonance plus faibles, donc plus de déplacement, donc plus de signal pour une même accélération.

Sur la figure 6B, on peut voir un dispositif D4' selon une variante de réalisation du dispositif D4.

Les moyens de guidage comportent deux bras 206', 208' disposés dans deux plans parallèles et articulés l'un par rapport à l'autre par une articulation 218'.

Une face latérale du bras 206' est en regard d'une face latérale du bras 208' et l'articulation 218' s'étend entre les deux faces latérales, plus particulièrement une barre de torsion s'étend entre les deux faces latérales.

Le bras 208' situé le plus à l'extérieur par rapport à l'élément mobile 4 présente une longueur supérieure à celle du bras 206'.

De manière avantageuse, l'articulation est formée par une poutre déformable en torsion.

La liaison pivot entre la poutre 206' et l'élément mobile est située au niveau d'une extrémité longitudinale 206.1' de la poutre 206', et la liaison pivot entre la poutre 206' et le support est située au niveau de l'autre extrémité longitudinale 206.2' de la poutre 206'.

La liaison pivot entre la poutre 208' et l'élément mobile 4 est située au niveau d'une extrémité longitudinale 208.1' de la poutre 208' et la liaison pivot entre la poutre 208' et le support est située au niveau de l'autre extrémité longitudinale 208.2' de la poutre 208'.

Le bras 208' situé le plus à l'extérieur par rapport à l'élément mobile 4 présente une longueur supérieure à celle du bras 206', de sorte que les articulations pivots entre le bras 208' et le support et entre le bras 208'et l'élément mobile soient à l'extérieur du bras 206' et ses articulations pivots. Ainsi, contrairement au dispositif D4, il n'y a pas de superposition entre une ou des articulations pivots et les bras.

Les liaisons pivots sont avantageusement réalisées par des poutres déformables en torsion.

Dans l'exemple représenté, l'élément mobile est structuré pour ménager un emplacement pour un plot d'ancrage P', ce qui permet de réduire l'encombrement. Il pourrait être prévu que l'élément mobile ne soit pas structuré et que le plot d'ancrage soit en avant de l'élément mobile dans l'exemple représenté.

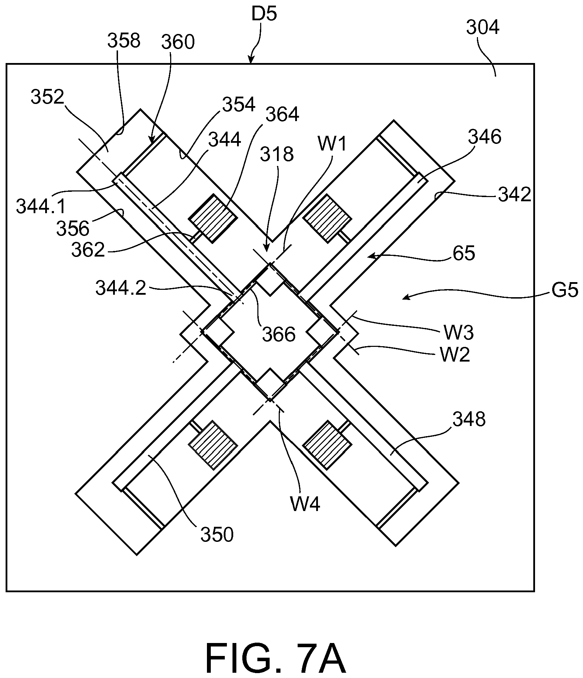

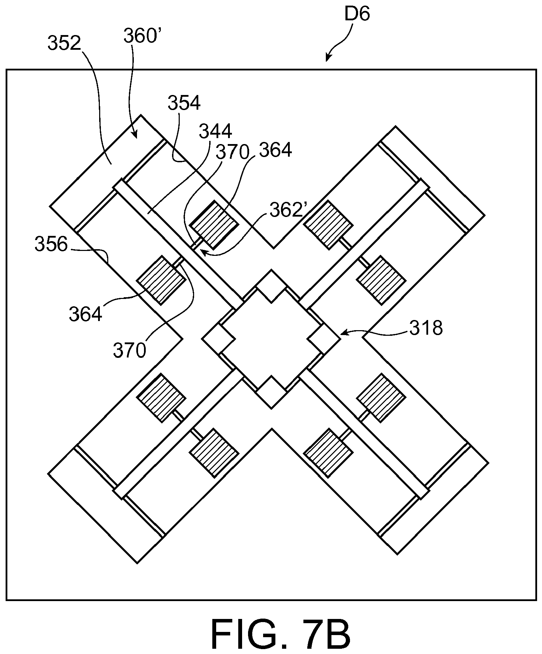

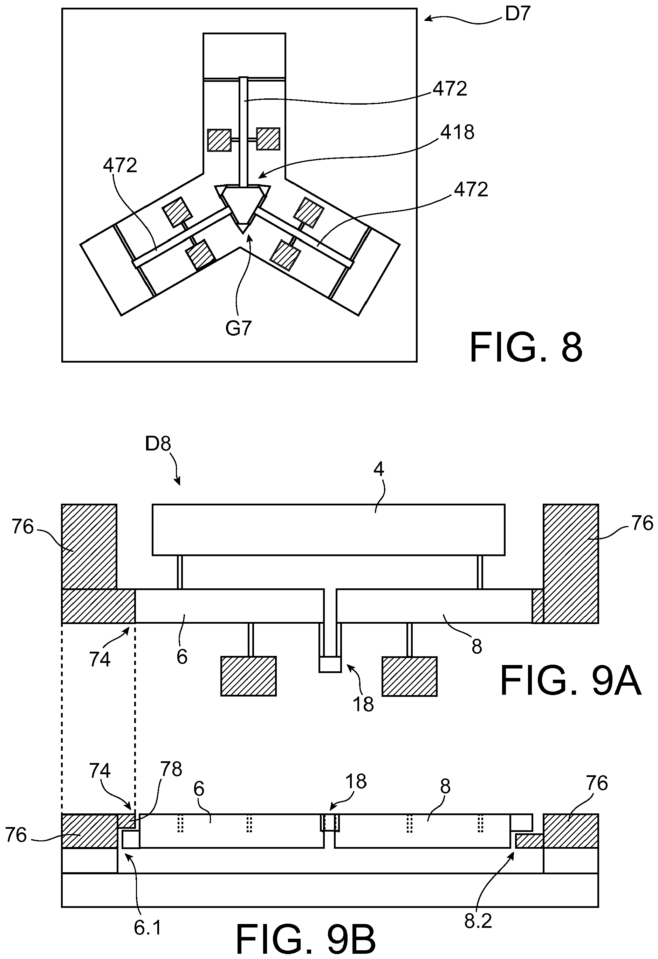

Sur les figures 7A, 7B et 8 on peut voir un dispositif selon un autre exemple de réalisation dans lequel les moyens de couplage sont situés à l'intérieur du périmètre de l'élément mobile.

Sur la figure 7A, le dispositif D5 comporte un élément mobile 304 muni d'une fenêtre traversant l'élément mobile 304 dans la direction Z, réalisée par exemple par gravure et des moyens de guidage G5 disposés dans la fenêtre 342.

Les moyens de guidage G5 comportent quatre bras rigides 344, 346, 348, 350 articulés en rotation d'une part sur l'élément mobile, d'autre part sur le support et enfin sur une articulation de couplage 318. Les axes des articulations pivots de chaque arbre sont parallèles entre eux.

Dans l'exemple représenté, la fenêtre 342 a une forme de croix dont les branches s'étendent le long de diagonales de l'élément mobile de forme rectangulaire.

Les bras sont disposés les uns par rapport aux autres de sorte à former une croix correspondant à la fenêtre 342.

Les quatre bras sont reliés à l'élément mobile, au support et à l'articulation de couplage de manière similaire, seules les liaisons du bras 344 seront décrites en détail.

Le bras 344 est disposé dans une branche 352 de la fenêtre 342.

La branche 352 comporte deux bords latéraux 354, 356 reliés par un bord longitudinal 358 situé à l'opposé du centre de la fenêtre.

Le bras 344 est relié à l'élément mobile 354 par une liaison pivot 360 entre le bord latéral 354 et une extrémité distale 344.1 du bras.

Le bras est relié au support 302 par une liaison pivot 362 s'étendant entre une zone centrale du bras et un plot d'ancrage 364 situé entre le bord latéral 354 et le bras 344. En variante, le plot d'ancrage peut être situé entre le bras 354 et l'autre bord latéral 356. Le bras 344 est relié à l'articulation de couplage 318 par son extrémité proximale 344.2. Dans l'exemple représenté, l'articulation de couplage 318 comporte un cadre formé de quatre poutres 366 connectées entre elles par des connecteurs rigides 370.

Les poutres sont aptes à se déformer en torsion. L'extrémité proximale 344.1 du bras 344 est fixée à une des poutres 366, de sorte que l'axe du bras 344 et l'axe W1 de la poutre 366 soient orthogonaux. Ainsi la liaison entre le bras 344 et l'articulation de couplage est une liaison pivot d'axe W1.

Les liaisons pivots 360 et 362 sont formées par des poutres déformables en torsion.

Les autres bras 344, 346, 348 et 350 sont articulés en rotation sur l'articulation de couplage autour d'axe W1, W2, W3, W4, les axes W1et W3 étant parallèles et perpendiculaires aux axes W2 et W4 parallèles entre eux.

Le déplacement hors-plan de l'élément mobile est autorisé par les liaisons pivots et la déformation transversale de l'articulation de couplage, les poutres 366 offrant une certaine aptitude à se déformer en flexion.

En variante, l'emplacement des liaisons pivots 360 et 362 pourraient être interverties, et/ou être situées à d'autres positions longitudinales du bras 344.

Sur la figure 7B, on peut voir une variante D6 de réalisation du dispositif D5. La liaison pivot 360' du dispositif D6 entre le bras 344 et l'élément mobile est formée par une poutre s'étendant entre les deux bords latéraux 354, 356 de la branche de la fenêtre. La liaison pivot 362' du dispositif D6 entre le bras 344 et le support comporte deux poutres 370 s'étendant de part et d'autre de l'axe du bras 344 et ancrées chacune sur un plot d'ancrage. Le dispositif D6 offre l'avantage par rapport à D5 d'une meilleure tenue de la masse. En outre les efforts sont symétrisés.

En variante, il peut être envisagé que l'une des liaisons pivots 354, 356 soit celle de du dispositif D5 et l'autre des liaisons pivots 356, 354 soit celle du dispositif D6.

Sur la figure 8, on peut voir un autre exemple de réalisation D7, dans lequel les moyens de guidage G7 comportent trois bras 472 articulés sur l'élément mobile et sur le support de manière similaire à celle décrite pour les dispositifs D5 et D6. Les bras sont couplés entre eux par une articulation de couplage 418 formé par un cadre triangulaire comprenant trois poutres déformables en torsion et formant les liaisons pivots entre les bras et l'articulation de couplage.

Les axes des liaisons pivots entre d'une part le bras et l'élément mobile, d'autre part le bras et le support et enfin entre le bras et l'articulation de couplage sont parallèles entre eux.

Le dispositif D7 présente l'avantage par rapport aux dispositifs D5 et D6 d'avoir une réduction de masse plus faible en ne mettant en œuvre que trois bras et de présenter une fréquence de résonance plus basse, tout en assurant le maintien dans les deux directions.

Selon un autre exemple de réalisation, le moyen de guidage des dispositifs D5 à D7 peut ne comporter que deux bras reliés par une articulation de couplage et disposés dans une fenêtre traversant l'élément mobile.

Sur les figures 9A à 9C, on peut voir un exemple avantageux d'un dispositif D8 selon l'invention.

Le dispositif D8 a une structure similaire à celle du dispositif D1 et comporte en plus des moyens de butée hors-plan 74

Les moyens de butée hors-plan sont à la fois portés par les moyens de guidage et le support.

Le support comporte des montants 76 situés sur les bords latéraux des moyens de guidage de part et d'autre de l'articulation de couplage.

Dans l'exemple représenté et de manière avantageuse, les moyens de butée hors-plan sont bidirectionnels. Mais il sera compris que les moyens de butée ne pourraient former une butée que dans un sens de déplacement hors-plan.

Les articulations pivots entre les bras et l'élément mobile sont disposées de telle sorte que les extrémités distales 6.1 et 8.2 soient en saillie par rapport à ces articulations pivots dans la direction X.

L'un des montants 76 comporte une saillie latérale 78 s'étendant au-dessus de l'extrémité distale 6.1 du bras 6 en considérant la direction Z. De manière avantageuse, l'extrémité distale 6.1 est structurée ce qui permet de rapprocher les structures et de réduire l'encombrement selon la direction Z.

L'autre montant 76 comporte une saillie latérale 80 s'étendant au-dessous de l'extrémité distale 8.2 du bras 8 en considérant la direction Z. De manière avantageuse l'extrémité distale 8.2 est structurée.

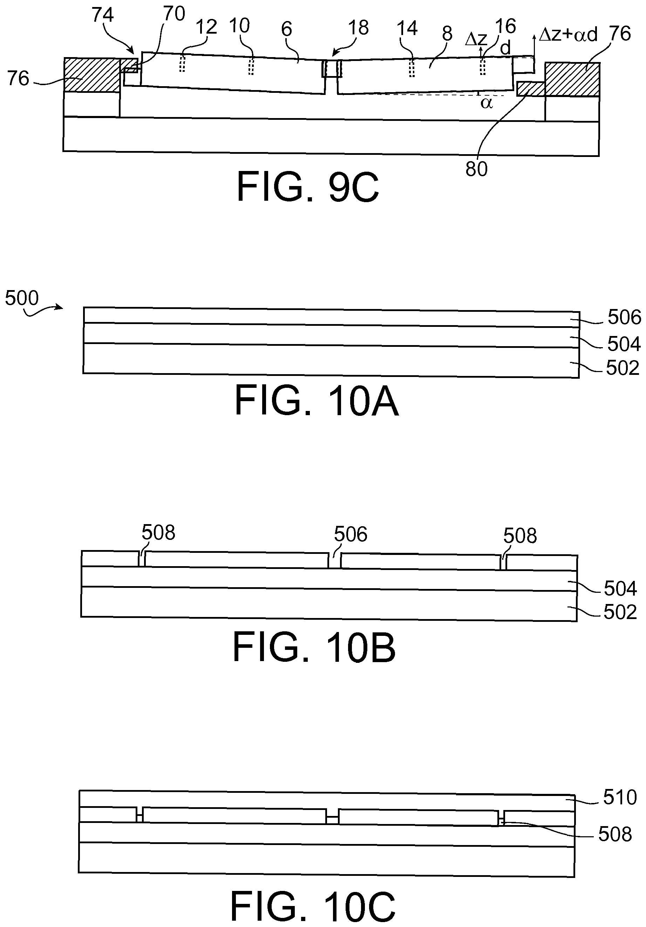

Sur la figure 9C, on peut voir l'extrémité distale 6.1 du bras 6 en butée contre la saillie latérale 78 du montant 76.

Dans cet exemple et de manière avantageuse, les moyens de butée interviennent avant que la masse n'entre en contact avec les électrodes destinées à la détection du déplacement. En effet, comme cela est schématisé sur la figure 9C, si l'élément mobile se déplace d'une distance Δz selon la direction Z en éloignement du support, que la distance entre la liaison pivot entre le bras et l'élément mobile et la butée est de d et que l'angle de pivotement des bras est a, alors l'extrémité distale 6.1 se déplace de Δz + αd.

De manière avantageuse, les extrémités distales 6.1, 8.2 susceptibles de venir en contact avec les montants 76 présentent une faible surface, ce qui réduit les risques de collage.

Dans d'autres exemples de réalisation, il peut être envisagé que les deux butées soient portées par le même bras, par exemple en structurant le bras.

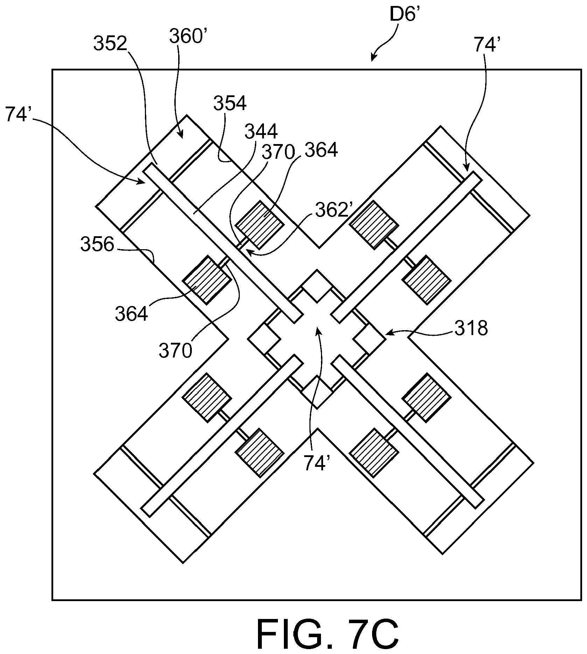

Sur la figure 7C, on peut voir une variante D6' de réalisation du dispositif D6 comporte de moyens de butée 74' formés par les extrémités longitudinales des bras qui sont telles que les axes des articulations pivots 360', 362'ne se situent pas au niveau des extrémités mais à des positions intermédiaires des bras. L'une ou l'autre des extrémités longitudinales de chaque bras vient en butée contre le support suivant le déplacement de la partie mobile.

Il sera compris que les moyens de butée hors-plan peuvent s'appliquer à tous les dispositifs D2 à D7 décrits ci-dessus.

Dans l'exemple des figures 2 et 3A et 3B, les moyens de guidage hors-plan G1 sont situés à l'extérieur de la structure. En variante, il peut être envisagé d'intervertir les moyens de suspension et les moyens de guidage, en disposant les moyens de guidage entre l'élément mobile et le plot d'ancrage 34, et en disposant les moyens de suspension à l'extérieur.

Les moyens de guidage des figures 1 à 6 pourraient comporter plus de deux bras, par exemple quatre bras articulés les uns aux autres, sur l'élément mobile et sur le support.

En outre dans le cas d'un dispositif comportant plusieurs moyens de guidage selon l'invention, ceux-ci pourraient avoir des structures différentes.

Un exemple de procédé de réalisation du dispositif D8 comportant des moyens de butée hors-plan va maintenant être décrit, à l'aide des figures 10A à 10G.

Ce procédé de réalisation met en œuvre deux couches mécaniques.

Dans cet exemple, on utilise un substrat silicium sur isolant ou SOI (Silicon on Insulator) 500, par exemple d'épaisseur 750 µm, comportant un support en silicium 502, une couche de SiO₂ 504 et une couche en silicium 506, la couche d'oxyde a par exemple une épaisseur de 2 µm. Ce substrat est représenté sur la figure 10A.

Lors d'une première étape, on réalise trois tranchées 508 par gravure de la couche 506 avec arrêt sur la couche d'oxyde 504, par exemple par gravure ionique réactive profonde ou DRIE (Deep Reactive Ion Etching), permettant de délimiter les moyens de guidage, en particulier les bras 6, 8.

L'élément ainsi obtenu est représenté sur la figure 10B.

Lors d'une étape suivante, les tranchées 508 sont bouchées par exemple avec de l'oxyde 510. L'oxydation peut être formée par oxydation thermique, ce qui a pour effet de remplir partiellement les tranchées et/ou par dépôt de l'oxyde sur toute la surface du substrat pour recouvrir les tranchées. La couche d'oxyde 510 recouvre toute la face avant du substrat. Cette étape pourra être suivi d'un polissage mécano-chimique.

L'élément ainsi obtenu est représenté sur la figure 10C.

Lors d'une étape suivante, on structure la couche d'oxyde 510 de sorte à former des ilots 511 qui serviront à la réalisation des liaisons pivots et des butées. La structuration peut être réalisée par gravure RIE (Reactive ionic Etching).

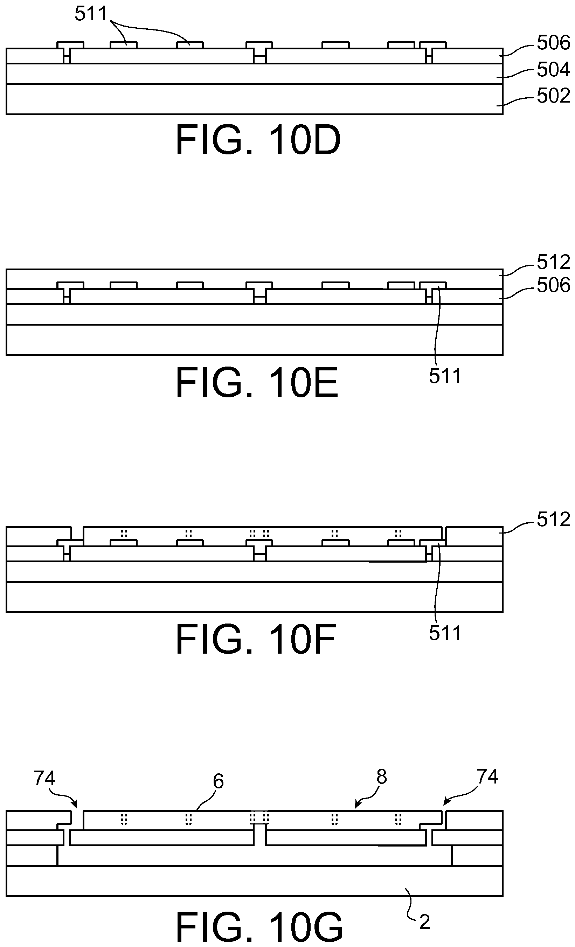

L'élément ainsi obtenu est représenté sur la figure 10D.

Lors d'une étape suivante, une couche de silicium épaisse 512, par exemple d'épaisseur comprise entre quelques µm et quelques dizaines de µm est formée sur la couche d'oxyde structurée, par exemple par croissance épitaxiale. Le silicium est formé entre les ilots et sur les ilots. En variante, un matériau conducteur différent de celui du substrat pourrait former la couche 512.

Un polissage mécano-chimique peut ensuite avoir lieu.

L'élément ainsi obtenu est représenté sur la figure 10E.

Lors d'une étape suivante, la couche 512 est structurée afin de délimiter au moins partiellement les bras et les liaisons pivots et l'élément mobile, avantageusement par gravure DRIE. Dans cet exemple, l'élément mobile et les moyens de guidage sont réalisés d'un seul tenant. Dans un autre exemple, les moyens de guidage peuvent être réalisés dans la couche 506, dans ce cas l'élément mobile et les moyens de guidage ne sont pas d'un seul tenant.

L'élément ainsi obtenu est représenté sur la figure 10F.

Lors d'une étape suivante, les moyens de guidage sont libérés en retirant les ilots et en partie la couche sacrificielle 504, par exemple en utilisant de l'acide fluorhydrique en phase vapeur.

Il résulte de cet exemple de procédé que les bras comportent deux couches de silicium formées lors de deux étapes différentes.

L'élément ainsi obtenu est représenté sur la figure 10G.

Cet exemple de procédé est particulièrement adapté pour la réalisation du dispositif D4 comportant une poutre formant liaison pivot s'étendant dans un plan situé sous le bras 8.

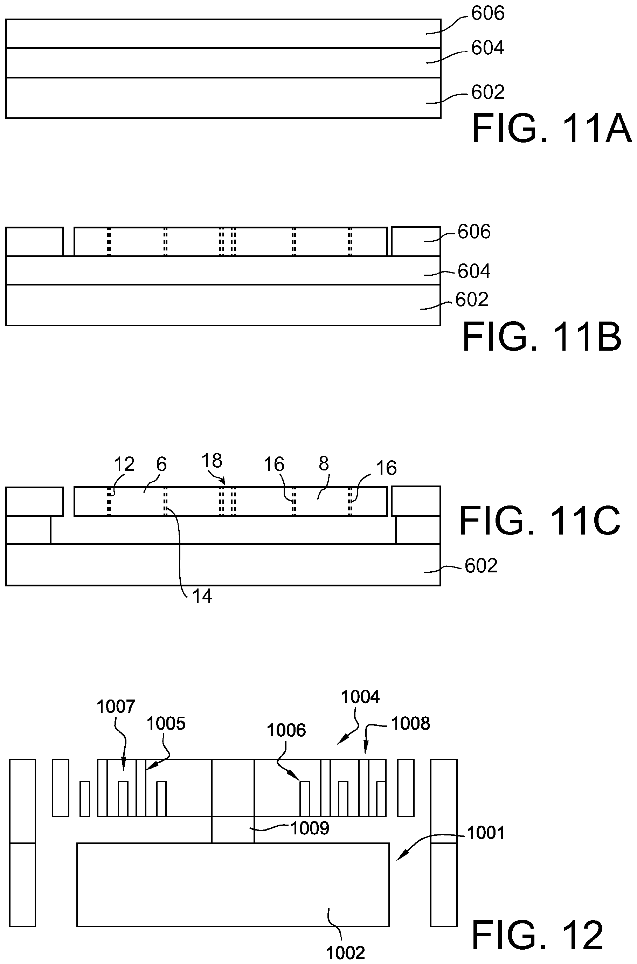

Sur les figures 11A à 11C, on peut voir un autre exemple de procédé ne mettant en œuvre qu'une couche mécanique. Dans cet exemple, on réalise le dispositif D1.

Dans cet exemple, on utilise un substrat comportant un support en silicium 602 et une couche de SiO₂ 604.

Lors d'une première étape, une couche en silicium 606 est formée sur la couche d'oxyde 604 destinée à former une couche sacrificielle, la couche 606 est formée par exemple par dépôt de polysilicium par dépôt physique en phase vapeur ou PVD (Physical Vapor Deposition en terminologie anglo-saxonne) ou par report.

L'élément ainsi obtenu est représenté sur la figure 11A.

Lors d'une étape suivante, on structure la couche 606 en vue de former les bras et articulations pivots. Les articulations pivots sont représentées en pointillés. La structuration est par exemple obtenue par gravure profonde.

L'élément ainsi obtenu est représenté sur la figure 11B.

Lors d'une étape suivante, on libère les moyens de guidage, en supprimant une partie de la couche sacrificielle 604, par exemple en utilisation de l'acide fluorhydrique en phase vapeur.

L'élément ainsi obtenu est représenté sur la figure 11C.

Par exemple le dispositif D4' peut être réalisé par le procédé des figures 11A à 11C.

Les moyens de guidage selon l'invention sont particulièrement adaptés à la mise en œuvre dans un capteur inertiel à déplacement hors-plan tel que celui représenté sur la figure 2. Ils limitent les non-linéarités dans les mesures de déplacement et les risques de contact entre les électrodes interdigitées.

Il sera compris que tels moyens s'appliquent à d'autres types de capteur inertiel mettant en œuvre d'autres moyens de détection, par exemple des moyens piézorésistifs. Ils s'appliquent également à des actionneurs à déplacement hors-plan et à tout autre dispositif comportant au moins un élément mobile et requérant un guidage selon la direction hors-plan.

## Revendications

1. Dispositif MEMS et/ou NEMS comportant un support et au moins un élément mobile (4, 304) de sorte à pouvoir se déplacer en translation par rapport au support dans une direction hors-plan par rapport à un plan du dispositif, au moins un moyen de guidage (G1, G5) en translation dudit élément, ledit moyen de guidage (G1, G5) comportant au moins deux bras rigides (6, 8, 344, 346, 348, 250) s'étendant longitudinalement, une articulation pivot (12, 16, 360) entre chaque bras (6, 8, 344, 346, 348, 350) et l'élément mobile (4, 304) et une articulation pivot (10, 14, 362) entre chaque bras (6, 8, 344, 346, 348, 350) et le support, le moyen de guidage (G1, G5) comportant également une articulation de couplage (18, 318) entre les deux bras comportant au moins une articulation pivot, au moins deux des articulations pivots reliées à chacun des bras ayant un degré de liberté en translation dans le plan du dispositif le long des bras, lesdites articulations pivots ayant des axes de rotation au moins parallèles entre eux de sorte que, lors d'un déplacement en translation de l'élément mobile (4, 304), les bras (6, 8, 344, 346, 348, 350) pivotent l'un par rapport à l'autre dans des sens opposés, **caractérisé en ce que** l'articulation de couplage est disposée entre des plans contenant les articulations pivots entre les bras et le support, lesdits plans étant parallèles à la direction hors-plan.

2. Dispositif MEMS et/ou NEMS selon la revendication 1, dans lequel les articulations pivots ayant un degré de liberté en translation dans le plan du dispositif le long des bras comportent au moins une poutre déformable en torsion.

3. Dispositif MEMS et/ou NEMS selon la revendication 1 ou 2, dans lequel l'articulation de couplage (18) comporte deux poutres (22, 24) déformables en torsion et un élément rigide (20) reliant les deux poutres (22, 24), les deux poutres (22, 24) étant par ailleurs fixées chacune à un bras (6, 8).

4. Dispositif MEMS et/ou NEMS selon la revendication 1 ou 2, dans lequel l'articulation de couplage comporte une seule poutre (120) déformable en torsion fixée aux deux bras, ladite poutre étant perpendiculaire aux axes longitudinaux des bras.

5. Dispositif MEMS et/ou NEMS selon la revendication précédente, dans lequel les deux bras sont dans deux plans parallèles distincts, chaque bras étant relié à l'élément mobile par une de ses extrémités longitudinales, au support par l'autre de ses extrémités longitudinales et la poutre de l'articulation de couplage s'étendant entre les deux bras dans des zones intermédiaires des bras entre leurs extrémités longitudinales.

6. Dispositif MEMS et/ou NEMS selon l'une des revendications précédentes, dans lequel le moyen de guidage (G1) est disposé le long d'au moins un bord extérieur de l'élément mobile (4).

7. Dispositif MEMS et/ou NEMS selon l'une des revendications précédentes, comportant au moins deux moyens de guidage.

8. Dispositif MEMS et/ou NEMS selon la revendication précédente, dans lequel les axes de rotation des deux moyens de guidage sont sécants entre eux.

9. Dispositif MEMS et/ou NEMS selon la revendication 1 ou 2, dans lequel le moyen de guidage (G5) comporte au moins trois bras (344, 346, 348, 350) et l'articulation de couplage (318) comporte au moins trois poutres déformable en torsion (366) reliées entre elles de sorte à former une forme fermée, chaque bras (344, 346, 348, 350) étant fixé à une poutre (366) de l'articulation de couplage (318) de sorte que l'axe longitudinal du bras soit perpendiculaire à l'axe de la poutre, par exemple le moyen de guidage (G5) étant disposé dans une fenêtre (342) formée à travers l'élément mobile (304) de sorte qu'il soit inclus dans le périmètre de l'élément mobile (304).

10. Dispositif MEMS et/ou NEMS selon la revendication 9, dans lequel les au moins trois bras (344, 346, 348) sont disposés les uns par rapport aux autres de sorte que l'articulation de couplage est disposée sensiblement au centre de la croix.

11. Dispositif MEMS et/ou NEMS selon l'une des revendications précédentes, comportant des moyens de butée hors-plan (76), lesdits moyens de butée (76) étant formés entre le support et au moins un bras (6, 8) d'au moins un moyen de guidage (G5).

12. Dispositif MEMS et/ou NEMS selon la revendication précédente, dans lequel les moyens de butée hors-plan (76) sont tels qu'ils forment au moins une première butée dans une premier sens de déplacement hors-plan, la première butée étant portée par un des bras (6) en coopération avec le support, avantageusement la première butée étant formée au niveau d'une extrémité longitudinale du bras (6) et l'articulation pivot (12) entre le bras (6) et l'élément mobile (4) étant située entre ladite extrémité longitudinale (6.1) du bras (6) et l'articulation de couplage (18), à l'exclusion de ladite extrémité longitudinale (6.1).

13. Dispositif MEMS et/ou NEMS selon la revendication précédente, dans lequel les moyens de butée hors-plan (76) sont tels qu'ils forment également une deuxième butée dans un deuxième sens de déplacement hors-plan.

14. Dispositif MEMS et/ou NEMS selon l'une des revendications précédentes, comportant des moyens de suspension (30) dudit élément mobile au support distincts du au moins un moyen de guidage.

15. Capteur inertiel comportant au moins un dispositif MEMS et/ou NEMS selon l'une des revendications précédentes, l'élément mobile formant une masse inertielle, et des moyens de détection du déplacement hors-plan de la masse inertielle, lesdits moyens de détection comportant avantageusement des électrodes interdigitées, une partie étant portée par la masse inertielle et l'autre partie étant portée par le support situé au-dessus de la masse inertielle.

## Patentansprüche

1. MEMS- und/oder NEMS-Vorrichtung, umfassend einen Träger und wenigstens ein Element (4, 304), das derart beweglich ist, dass es sich in Translation mit Bezug zu dem Träger bezogen auf eine Ebene der Vorrichtung in einer Richtung aus der Ebene verlagern kann, wenigstens ein Mittel (G1, G5) zur Translationsführung des Elements, wobei das Führungsmittel (G1, G5) wenigstens zwei starre Arme (6, 8, 344, 346, 348, 250) umfasst, die sich longitudinal erstrecken, ein Schwenkgelenk (12, 16, 360) zwischen jedem Arm (6, 8, 344, 346, 348, 350) und dem beweglichen Element (4, 304), und ein Schwenkgelenk (10, 14, 362) zwischen jedem Arm (6, 8, 344, 346, 348, 350) und dem Träger, wobei das Führungsmittel (G1, G5) ferner ein Kopplungsgelenk (18, 318) zwischen den zwei Armen umfasst, umfassend wenigstens ein Schwenkgelenk, wobei wenigstens zwei der Schwenkgelenke, die mit jedem der Arme verbunden sind, einen Translationsfreiheitsgrad in der Ebene der Vorrichtung entlang der Arme haben, wobei die Schwenkgelenke Drehachsen haben, die wenigstens zueinander parallel sind, derart, dass bei einer Translationsverlagerung des beweglichen Elements (4, 304) die Arme (6, 8, 344, 346, 348, 350) relativ zueinander in entgegengesetzten Richtungen schwenken, **dadurch gekennzeichnet, dass** das Kopplungsgelenk zwischen Ebenen angeordnet ist, die die Schwenkgelenke zwischen den Armen und dem Träger enthalten, wobei die Ebenen parallel zu der Richtung aus der Ebene sind.

2. MEMS- und/oder NEMS-Vorrichtung nach Anspruch 1, bei der die Schwenkgelenke, die einen Translationsfreiheitsgrad in der Ebene der Vorrichtung entlang der Arme haben, wenigstens einen torsionsverformbaren Balken umfassen.

3. MEMS- und/oder NEMS-Vorrichtung nach Anspruch 1 oder 2, bei der das Kopplungsgelenk (18) zwei torsionsverformbare Balken (22, 24) und ein starres Element (20) umfasst, das die zwei Balken (22, 24) verbindet, wobei die zwei Balken (22, 24) ferner jeweils an einem Arm (6, 8) befestigt sind.

4. MEMS- und/oder NEMS-Vorrichtung nach Anspruch 1 oder 2, bei der das Kopplungsgelenk einen einzigen torsionsverformbaren Balken (120) umfasst, der an zwei Armen befestigt ist, wobei der Balken orthogonal zu den longitudinalen Achsen der Arme ist.

5. MEMS- und/oder NEMS-Vorrichtung nach dem vorhergehenden Anspruch, bei der die zwei Arme in zwei verschiedenen parallelen Ebenen sind, wobei jeder Arm mit dem beweglichen Element an einem seiner longitudinalen Enden verbunden ist, mit dem Träger an dem anderen seiner longitudinalen Enden, und sich der Balken des Kopplungsgelenks zwischen den zwei Armen in Zwischenzonen der Arme zwischen ihren longitudinalen Enden erstreckt.

6. MEMS- und/oder NEMS-Vorrichtung nach einem der vorhergehenden Ansprüche, bei der das Führungsmittel (G1) entlang wenigstens eines äußeren Rands des beweglichen Elements (4) angeordnet ist.

7. MEMS- und/oder NEMS-Vorrichtung nach einem der vorhergehenden Ansprüche, umfassend wenigstens zwei Führungsmittel.

8. MEMS- und/oder NEMS-Vorrichtung nach dem vorhergehenden Anspruch, bei der sich die Drehachsen der zwei Führungsmittel schneiden.

9. MEMS- und/oder NEMS-Vorrichtung nach Anspruch 1 oder 2, bei der das Führungsmittel (G5) wenigstens drei Arme (344, 346, 348, 350) umfasst, und das Kopplungsgelenk (318) wenigstens drei torsionsverformbare Balken (366) umfasst, die miteinander derart verbunden sind, dass sie eine geschlossene Form bilden, wobei jeder Arm (344, 346, 348, 350) an einem Balken (366) des Kopplungsgelenks (318) derart befestigt ist, dass die longitudinale Achse des Arms orthogonal zur Achse des Balkens ist, wobei beispielsweise das Führungselement (G5) in einem Fenster (342) angeordnet ist, das durch das bewegliche Element (304) hindurch gebildet ist, derart, dass es in dem Umfang des beweglichen Elements (304) eingeschlossen ist.

10. MEMS- und/oder NEMS-Vorrichtung nach Anspruch 9, bei der die wenigstens drei Arme (344, 346, 348) relativ zueinander derart angeordnet sind, dass das Kopplungsgelenk im Wesentlichen im Zentrum des Kreuzes angeordnet ist.

11. MEMS- und/oder NEMS-Vorrichtung nach einem der vorhergehenden Ansprüche, umfassend Anschlagsmittel außerhalb der Ebene (76), wobei die Anschlagsmittel (76) zwischen dem Träger und wenigstens einem Arm (6, 8) wenigstens eines Führungsmittels (G5) gebildet sind.

12. MEMS- und/oder NEMS-Vorrichtung nach dem vorhergehenden Anspruch, bei der die Anschlagsmittel außerhalb der Ebene (76) derart sind, dass sie wenigstens einen ersten Anschlag in einer ersten Verlagerungsrichtung aus der Ebene bilden, wobei der erste Anschlag durch einen der Arme (6) in Zusammenwirkung mit dem Träger getragen wird, wobei vorzugsweise der erste Anschlag im Bereich eines longitudinalen Endes des Arms (6) gebildet ist, und das Schwenkgelenk (12) zwischen dem Arm (6) und dem beweglichen Element (4) zwischen dem longitudinalen Ende (6.1) des Arms (6) und dem Kopplungsgelenk (18) angeordnet ist, ausgenommen das longitudinale Ende (6.1).

13. MEMS- und/oder NEMS-Vorrichtung nach dem vorhergehenden Anspruch, bei der die Anschlagsmittel außerhalb der Ebene (76) derart sind, dass sie ferner einen zweiten Anschlag in einer zweiten Verlagerungsrichtung aus der Ebene bilden.

14. MEMS- und/oder NEMS-Vorrichtung nach einem der vorhergehenden Ansprüche, umfassend Mittel (30) zur Aufhängung des beweglichen Elements an dem Träger, die von dem wenigstens einen Führungsmittel verschieden sind.

15. Trägheitssensor, umfassend wenigstens eine MEMS- und/oder NEMS-Vorrichtung nach einem der vorhergehenden Ansprüche, wobei das bewegliche Element eine träge Masse bildet, sowie Mittel zur Detektion der Verlagerung der trägen Masse aus der Ebene, wobei die Detektionsmittel vorzugsweise Interdigitalelektroden umfassen, von denen ein Teil durch die träge Masse getragen wird und der andere Teil durch den Träger getragen wird, der über der trägen Masse angeordnet ist.

## Claims

1. MEMS and/or NEMS device comprising a support and at least one moveable element (4, 304) so as to be able to be translationally displaced with respect to the support in an out-of-plane direction with respect to a plane of the device, at least one guiding means (G1, G5) for translationally guiding said element, said guiding means comprising at least two rigid arms (6, 8, 344, 346, 348, 250) extending longitudinally, a pivot articulation (12, 16, 360) between each arm (6, 8, 344, 346, 348, 350) and the moveable element (4, 304) and a pivot articulation (10, 14, 362) between each arm (6, 8, 344, 346, 348, 350) and the support, the guiding means (G1, G5) also comprising a coupling articulation (18, 138) between the two arms comprising at least one pivot articulation, at least two pivot articulations connected to each of the arms having a translational degree of freedom in the plane of the device along the arms, said pivot articulations having axes of rotation at least parallel with each other such that, during a translational displacement of the moveable element (4, 304), the arms (6, 8, 344, 346, 348, 350) pivot with respect to each other in opposite directions, **characterized in that** the coupling articulation is arranged between planes containing the pivot articulations between the arms and the support, said planes being parallel to the out-of-plane direction.

2. MEMS and/or NEMS device according to claim 1, wherein the pivot articulations having a translational degree of freedom in the plane of the device along the arms comprise at least one torsionally deformable beam.

3. MEMS and/or NEMS device according to claim 1 or 2, wherein the coupling articulation (18) comprises two torsionally deformable beams (22, 24) and a rigid element (20) connecting the two beams (22, 24), the two beams (22, 24) being furthermore each fixed to an arm (6, 8).

4. MEMS and/or NEMS device according to claim 1 or 2, wherein the coupling articulation comprises a single torsionally deformable beam (120) fixed to the two arms, said beam being perpendicular to the longitudinal axes of the arms.

5. MEMS and/or NEMS device according to the previous claim, wherein the two arms are in two distinct parallel planes, each arm being connected to the moveable element by one of its longitudinal ends, to the support by the other of its longitudinal ends and the beam of the coupling articulation extending between the two arms in intermediate zones of the arms between their longitudinal ends.

6. MEMS and/or NEMS device according to one of the preceding claims, wherein the guiding means (G1) is arranged along at least one outer edge of the moveable element (4).

7. MEMS and/or NEMS device according to one of the preceding claims, comprising at least two guiding means.

8. MEMS and/or NEMS device according to the previous claim, wherein the axes of rotation of the two guiding means are secant to each other.

9. MEMS and/or NEMS device according to claim 1 or 2, wherein the guiding means (G5) comprises at least three arms (344, 346, 348, 350) and the coupling articulation (318) comprises at least three torsionally deformable beams (366) connected to each other so as to form a closed shape, each arm (344, 346, 348, 350) being fixed to a beam (366) of the coupling articulation (318) such that the longitudinal axis of the arm is perpendicular to the axis of the beam, for example the guiding means (G5) being arranged in a window (342) formed through the moveable element (304) such that it is included in the perimeter of the moveable element (304).

10. MEMS and/or NEMS device according to claim 9, wherein the at least three arms (344, 346, 348) are arranged with respect to each other such that the coupling articulation is arranged substantially at the centre of the cross.

11. Device according to one of the preceding claims, comprising one out-of-plane abutment means (76), said out-of-plane abutment means (76) being formed between the support and at least one arm (6, 8) of at least one guiding means.

12. Device according to the previous claim, wherein said the out-of-plane abutment means (76) are such that they form at least one first abutment in a first out-of-plane displacement direction, the first abutment being supported one of the arms (6) in cooperation with the support, advantageously the first out-of-plane abutment is formed at a longitudinal end of the arm (6) and the pivot articulation (12) between the arm (6) and the moveable element (4) being situated between said longitudinal end (6.1) of the arm (6) and the coupling articulation (18), except for said longitudinal end (6.1).

13. MEMS and/or NEMS device according to the previous claim, wherein the out-of-plane abutment means (76) are such that they3also form a second abutment in a second out-of-plane displacement direction.

14. MEMS and/or NEMS device according to one of the preceding claims, comprising suspension means (30) for suspending said moveable element from the support distinct from the at least one guiding means.

15. Inertial sensor comprising at least MEMS and/or NEMS device according to one of the preceding claims, the moveable element forming an inertial mass, and detection means for detecting the out-of-plane displacement of the inertial mass, said detection means advantageously co interdigitated electrodes, one part being borne by the inertial mass and the other part being borne by the support situated above the inertial mass.
